(19) Europäisches Patentamt
European Patent Office
Office européen des brevets

(11) **EP 1 391 037 B1**

(12) **EUROPÄISCHE PATENTSCHRIFT**

(45) Veröffentlichungstag und Bekanntmachung des Hinweises auf die Patenterteilung:
**10.10.2007 Patentblatt 2007/41**

(21) Anmeldenummer: **02766603.1**

(22) Anmeldetag: **10.04.2002**

(51) Int Cl.:
***H03H 9/145*** *(2006.01)*

(86) Internationale Anmeldenummer:
**PCT/DE2002/001322**

(87) Internationale Veröffentlichungsnummer:
**WO 2002/089324 (07.11.2002 Gazette 2002/45)**

(54) **TRANSVERSALFILTER MIT VERBESSERTER FALLENCHARAKTERISTIK**

TRANSVERSAL FILTER COMPRISING AN IMPROVED NOTCH CHARACTERISTIC CURVE

FILTRE TRANSVERSAL A CARACTERISTIQUE COUPE-FREQUENCE AMELIOREE

(84) Benannte Vertragsstaaten:
**AT BE CH CY DE DK ES FI FR GB GR IE IT LI LU MC NL PT SE TR**

(30) Priorität: **30.04.2001 DE 10121251**

(43) Veröffentlichungstag der Anmeldung:
**25.02.2004 Patentblatt 2004/09**

(73) Patentinhaber: **EPCOS AG**
**81669 München (DE)**

(72) Erfinder: **SCHEMIES, Michael**
**85630 Grasbrunn (DE)**

(74) Vertreter: **Epping - Hermann - Fischer**
**Ridlerstrasse 55**
**80339 München (DE)**

(56) Entgegenhaltungen:
**US-A- 4 075 582     US-A- 4 472 653**
**US-A- 4 910 483**

- **BAUSK E V ET AL: "Design of low-shape-factor SAW filters having a single acoustic track" FREQUENCY CONTROL SYMPOSIUM, 1996. 50TH., PROCEEDINGS OF THE 1996 IEEE INTERNATIONAL. HONOLULU, HI, USA 5-7 JUNE 1996, NEW YORK, NY, USA,IEEE, US, 5. Juni 1996 (1996-06-05), Seiten 291-295, XP010200079 ISBN: 0-7803-3309-8**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Gegenstand der Erfindung ist ein Oberflächenwellentransversalfilter, wie es insbesondere als Zwischenfrequenz-filter oder frequenzgenaues Übertragungsfilter in der Unterhaltungselektronik eingesetzt wird.

Oberflächenwellentransversalfilter, auch SAW-Transversalfilter oder im folgenden kurz nur Transversalfilter genannt, sind beispielsweise aus "SAW Components, Data Book 1996" der Siemens Matsushita Components bekannt und dort im Kapitel "General technical information" auf den Seiten 27ff beschrieben. Diese Transversalfilter sind auf einem kristallinen piezoelektrischen Substrat aufgebaut und besitzen zwei Interdigitalwandler, die als Ein- beziehungsweise Ausgangswandler dienen. Der Eingangswandler, an dem das zu filternde Signal angelegt wird, weist eine Wichtung auf, mit deren Hilfe die Übertragungsfunktion geformt wird. Der Ausgangswandler dagegen ist relativ zum Eingangswandler kurz und ungewichtet, weist also gleiche Überlappungslängen für alle Elektrodenfinger am Interdigitalwandler auf. Ein solcher ungewichteter Interdigitalwandler besitzt eine Übertragungsfunktion $\dfrac{\sin(x)}{x}$.

Die genaue Ausbildung der Wichtung des Eingangswandlers ist Ergebnis einer mit an sich bekannten mit geeigneten Softwaretools durchgeführten Optimierung. Weist das Ergebnis einer solchen Optimierung, also ein mittels Software optimiertes Filter eine real gemessene Charakteristik auf, die nicht mit der gewünschten Charakteristik übereinstimmt, so sind verschiedene Verfahren zur Meßkorrektur bekannt. Im wesentlichen wird dazu die Überlappungslänge der Elektrodenfinger im Eingangswandler variiert. In einer Reihe von Fällen führt jedoch eine derartige Meßkorrektur nach der Softwareoptimierung nicht zu dem gewünschten Erfolg. Insbesondere können solche nicht optimalen Filter ein Übertragungsverhalten aufweisen, das für bestimmte Frequenzen ein nur ungenügendes Dämpfungsverhalten zeigt. Beispielsweise kann eine solche Übertragungskurve eine zu geringe Selektion gegenüber einem Nachbarkanal oder gegenüber einer störenden Frequenz, beispielsweise der Spiegel- oder Image-Frequenz aufweisen. Wenn die genannten herkömmlichen Meßkorrekturen zur Herstellung der gewünschten Übertragungscharakteristik nicht ausreichen, ist ein Neudesign, also eine neue Optimierung mit veränderten Randbedingungen erforderlich, die nur aufwendig durchzuführen ist und die aber auch nicht notwendigerweise zu einer verbesserten Übertragungscharakteristik und insbesondere einer verbesserten Fallencharakteristik (= Ausfilterung bestimmter Frequenzen) führt.

Aus der US 4 472 653 A ist ein SAW Filter bekannt, bei dem Ein- und Ausgangswandler eine Überlappungswichtung mit unterschiedlichen Wichtungsfunktionen der beiden Wandler aufweisen

Aufgabe der vorliegenden Erfindung ist es daher, ein Transversalfilter mit verbesserter Fallencharakteristik anzugeben, mit dem ein software-optimiertes Design bezüglich der Fallencharakteristik schnell und effizient verbessert werden kann.

Diese Aufgabe wird erfindungsgemäß durch ein Transversalfilter mit den Merkmalen von Anspruch 1 gelöst. Vorteilhafte Ausgestaltungen der Erfindung sind in den Unteransprüchen angegeben.

Die Erfindung schlägt vor, für ein solches bekanntes Transversalfilter neben der Primärwichtung des Eingangswandlers auch den Ausgangswandler mit einer Wichtung zu versehen, die eine Sekundärwichtung darstellt und wesentlich geringere Gewicht aufweist als die Primärwichtung am Eingangswandler. Mit der Erfindung kann die Fallencharakteristik eines erfindungsgemäßen Transversalfilters wesentlich verbessert werden, was angesichts der anteilig kleinen Sekundärwichtung ein überraschendes Ergebnis ist. Die Meßkorrektur kann in kurzer Zeit erfolgen, beispielsweise innerhalb einer Stunde und ist daher weitaus weniger aufwendig als ein ohne die Erfindung erforderliches Neudesign des gesamten Transversalfilters.

Als Wichtungsmethode für die Sekundärwichtung wird ebenso wie für die Primärwichtung am Eingangswandler eine Überlappungswichtung vorgesehen. Das Ausmaß der Wichtung, also die Stärke der Wichtung wird üblicherweise in Prozentsätzen relativ zur Apertur des Ausgangswandlers angegeben und beträgt erfindungsgemäß maximal 0,5 bis 10 % derselben. Diese als Länge definierte maximale Wichtung entspricht dem Unterschied zwischen der geringsten und der größten Überlappungslänge zweier benachbarter Elektrodenfinger, die an unterschiedlichen Stromsammelschienen (Busbars) angebunden sind und daher unterschiedliche Polarität aufweisen.

Eine neuartige Methode zur Verbesserung der Fallencharakteristik liegt erfindungsgemäß darin, die Sekundärwichtung im Ausgangswandler überwiegend außerhalb der akustischen Spur vorzunehmen. Die Wichtung des Ausgangswandlers kann erfindungsgemäß zumindest zu 95% außerhalb der akustischen Spur liegen. Als akustische Spur ist dabei die Fläche zwischen zwei parallel zur Achse der Wellenausbreitungsrichtung gelegenen Geraden definiert, die auf Seiten des Eingangswandlers durch die Apertur des Eingangswandlers begrenzt ist. Demzufolge weist der Ausgangswandler auch eine größere Apertur als der Eingangswandler auf. Der Unterschied zwischen den beiden Aperturen sollte dabei zumindest 1% betragen und wird üblicherweise auf nicht mehr als 10 % eingestellt.

Ein erfindungsgemäßes Transversalfilter besitzt einen Eingangswandler, dessen in der Achse der Wellenausbreitung gemessene Länge zumindest ein Dreifaches der Länge des Ausgangswandlers aufweist. Die verbesserte Fallencharakteristik wird also trotz der relativ geringen Sekundärwichtung und der relativ geringen Länge des Ausgangswandlers, die mit einer entsprechend geringeren Anzahl an Überlappungen verbunden ist, erzielt.

Im folgenden wird die Erfindung anhand eines Ausführungsbeispiels und der dazugehörigen vier Figuren näher erläutert.

Figur 1 zeigt ein bekanntes Transversalfilter

Figur 2 zeigt einen Ausgangswandler für ein erfindungsgemäßes Transversalfilter

Figur 3 zeigt das Übertragungsverhalten eines bekannten Transversalfilters verglichen mit dem berechneten Übertragungsverhalten eines erfindungsgemäßen Transversalfilters

Figur 4 zeigt das Übertragungsverhalten eines bekannten Transversalfilters verglichen mit dem real gemessenen Übertragungsverhalten eines erfindungsgemäßen Transversalfilters

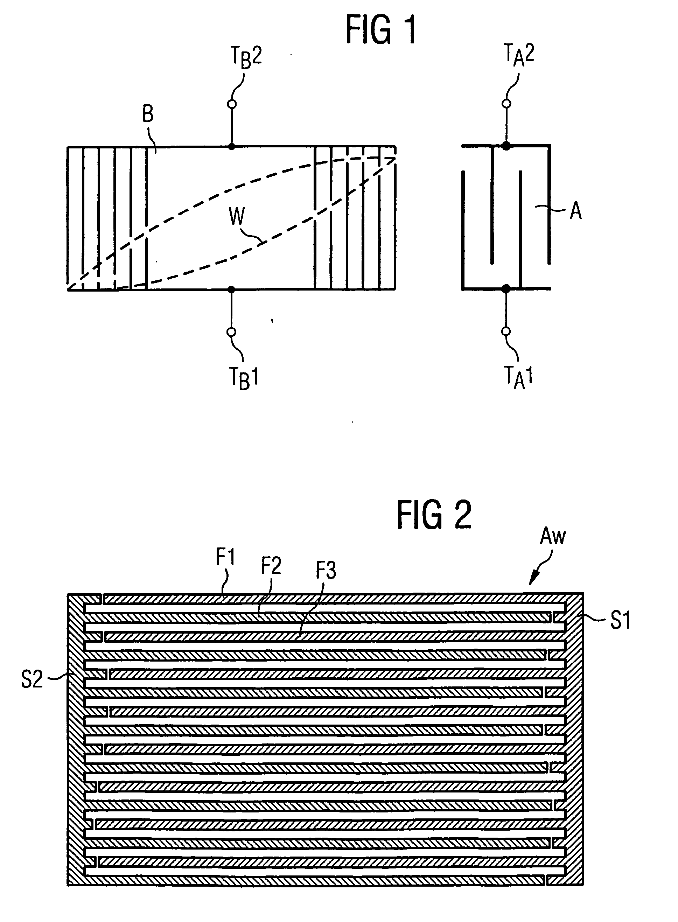

Figur 1 zeigt in schematischer nicht maßstabsgetreuer Darstellung ein bekanntes Transversalfilter mit einem Eingangswandler B und einem Ausgangswandler A, die auf der Oberfläche eines piezoelektrischen Substrats angeordnet sind. In der gezeigten Darstellung ist der Eingangswandler als überlappgewichteter Splitfingerwandler, der Ausgangswandler A als ungewichteter Normalfingerwandler ausgebildet. Mit W1 ist zu Veranschaulichung der beispielhaft dargestellten Wichtung die Hüllkurve für die Überlappungslängen benachbarter von unterschiedlichen Stromsammelschienen ausgehender Elektrodenfinger bezeichnet. Der Ausgangswandler A weist außerdem eine geringere Länge als der Eingangswandler B auf.

Das Eingangssignal wird beim Betrieb des Filters an die Anschlüsse $T_B1$ und $T_B2$ angelegt, während das Ausgangssignal an den Anschlüssen $T_A1$ und $T_A2$ abgegriffen werden kann.

Figur 2 zeigt einen erfindungsgemäßen Ausgangswandler $A_W$ in nahezu realer Darstellung, der mit einer erfindungsgemäßen Sekundärwichtung ausgestattet ist. Ein solcher Wandler kann in einem der z.B. in Figur 1 dargestellten Transversalfilter an die Stelle der dortigen Normalfingerwandler A eingesetzt werden. Aus der Figur 2 ist klar ersichtlich, daß die im erfindungsgemäßen Ausgangswandler $A_W$ verwendeten Überlappwichtungen ein nur geringes Gewicht aufweisen, der Unterschied zwischen der geringsten und der größten Überlappung beachbarter von unterschiedlichen Stromsammelschienen S1, S2 ausgehender Elektrodenfinger F1, F2, F3.. daher nur gering ist. Die maximale Wichtung beträgt zwischen 0,5 und 10 % bezogen auf die Apertur des Ausgangswandlers und beträgt in einem speziellen Fall 5,43 % der Gesamtapertur des Ausgangswandlers $A_W$.

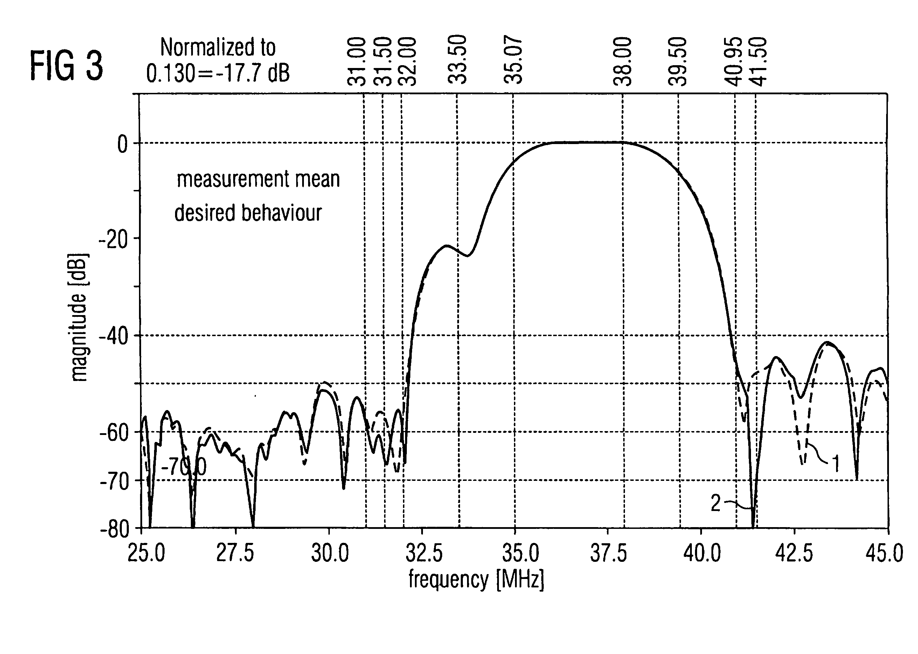

In Figur 3 ist das gemessene Übertragungsverhalten eines bekannten Transversalfilters (Meßkurve 1, gestrichelte Linie) mit ungewichtetem Ausgangswandler A dem berechneten Übertragungsverhalten eines erfindungsgemäßen Filters (Meßkurve 2, durchgezogene Linie) gegenübergestellt. Das mit einer Software optimierte Design zeigt in der Modellrechnung bei einer hier gegebenen Fallenfrequenz von 41,5 MHz eine verbesserte Selektion, die sich in einer verbesserten Dämpfung bei der genannten Frequenz auswirkt.

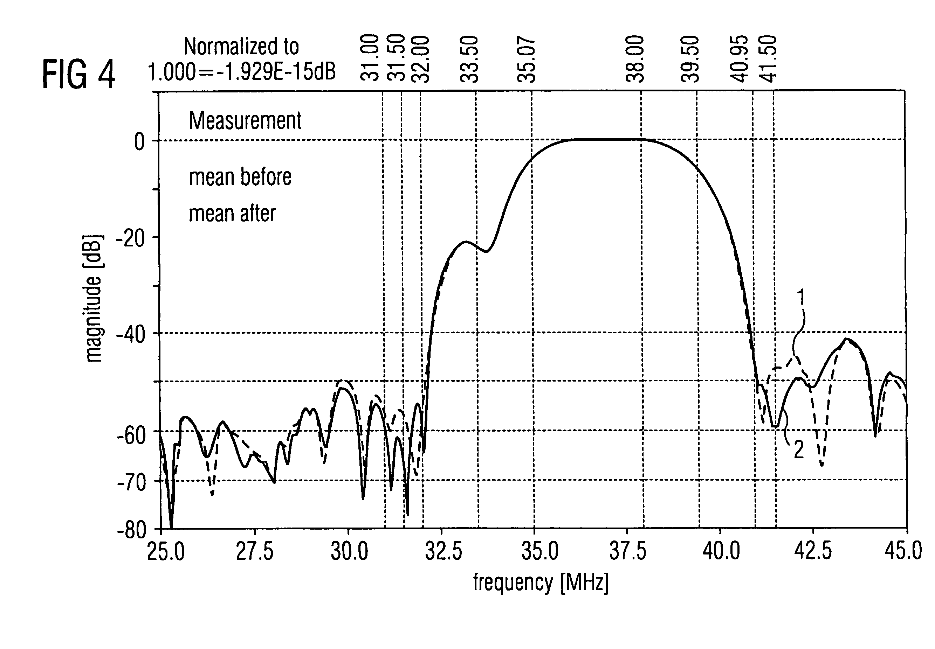

In Figur 4 wiederum ist das real gemessene Übertragungsverhalten eines bekannten Transversalfilters mit ungewichtetem Ausgangswandler A (Meßkurve 1 gestrichelte Linie) dem real gemessenen Übertragungsverhalten (Meßkurve 2, durchgezogene Linie) eines erfindungsgemäßen Transversalfilters gegenübergestellt. Es zeigt sich, daß die Meßkurve 2 des erfindungsgemäßen Filters zwar nicht ganz die erwartete überragende Fallencharakteristik aufweist, dennoch ist das erfindungsgemäße Filter bei der Fallenfrequenz von 41,5 MHz mit einer um zirka 11 dB verbesserten Selektion ausgestattet. Bei ansonsten im Paßband unveränderten Übertragungsverhalten, was für die Übertragungseigenschaften und die Frequenzgenauigkeit des Filters von Bedeutung ist, ist das erfindungsgemäße Filter durch die genannte verbesserte Fallencharakteristik insgesamt verbessert.

Neben der beispielhaft gewählten Falle bei 41,5 MHz sind mit der Erfindung selbstverständlich auch Optimierungen bezüglich anderer einzelner oder auch mehrerer Fallen parallel möglich.

Damit zeigt sich, daß mit der erfindungsgemäßen Sekundärwichtung im Ausgangswandler eines erfindungsgemäßen Transversalfilters ein insgesamt besseres Übertragungsverhalten erzielt werden kann, mit dem insbesondere durch gezielte und schnell mögliche Optimierung eine verbesserte Selektion bei Fallenfrequenzen erreicht werden kann.

**Patentansprüche**

1. SAW-Transversalfilter,

- umfassend ein piezoelektrisches Substrat mit je einem als Eingangs- (B) und Ausgangswandler (A) ausgebildeten Interdigitalwandler,
- bei dem der Eingangswandler zur Formung der Übertragungsfunktion eine Primärwichtung aufweist,
- bei dem die Apertur $Ap_B$ des Eingangswandlers kleiner ist als die Apertur $Ap_A$ des Ausgangswandlers,
- bei dem der Ausgangswandler ($A_W$) zur Verbesserung der Fallencharakteristik eine Sekundärwichtung aufweist, die wesentlich geringer ist als die Primärwichtung,
- bei dem als Wichtungsmethode für Primär- und Sekundärwichtung eine Überlappungswichtung vorgesehen ist

- bei dem die max. Sekundärwichtung im Ausgangswandler (A$_w$), definiert als der Unterschied zwischen der geringsten und der größten Überlappungslänge zweier benachbarer Elektrodenfinger unterschiedlicher Polarität, zwischen 0,5% und 10 % der Apertur des Ausgangswandlers (A) beträgt.

2. Transversalfilter nach Anspruch 1,
bei dem mindestens 95% der Überlappungswichtungen des Ausgangswandlers (A$_W$) außerhalb der durch die Apertur des Eingangswandlers definierten Spur des Filters liegen.

3. Transversalfilter nach einem der Ansprüche 1 oder 2,
bei dem die in der Achse (X) der Wellenausbreitung der Oberflächenwelle gemessene Länge des Eingangswandlers (B) zumindest ein dreifaches der Länge des Ausgangswandlers (A$_W$) beträgt.

4. Transversalfilter nach einem der Ansprüche 1 - 3,
bei dem die Sekundärwichtung auf eine maximale Dämpfung des Filters bei einer gegebenen Fallenfrequenz optimiert ist.

5. Verwendung des Transversalfilters nach einem der vorangehenden Ansprüche als Zwischenfrequenzfilter in der Unterhaltungselektronik oder für frequenzgenaue Anwendungen.

**Claims**

1. SAW transversal filter,

- comprising a piezoelectrical substrate having a respective interdigital transducer in the form of an input transducer (B) and an output transducer (A),
- in which the input transducer has a primary weighting for shaping the transfer function,
- in which the aperture ApB of the input transducer is smaller than the aperture ApA of the output transducer,
- in which the output transducer (AW) has a secondary weighting, which is much lower than the primary weighting, for improving the trap characteristic,
- in which the weighting method provided for primary and secondary weighting is overlap weighting,
- in which the maximum secondary weighting in the output transducer (AW), defined as the difference between the shortest and the longest overlap length of two adjacent electrode fingers having different polarity, is between 0.5% and 10% of the aperture of the output transducer (A).

2. Transversal filter according to one Claim 1,
in which at least 95% of the overlap weightings of the output transducer (AW) are outside the filter's track defined by the input transducer's aperture.

3. Transversal filter according to one of Claims 1 and 2,
in which the length of the input transducer (B), measured in the axis (X) of the surface wave's wave propagation, is at least triple the length of the output transducer (AW).

4. Transversal filter according to one of Claims 1-3,
in which the secondary weighting is optimized for maximum attenuation in the filter for a given trap frequency.

5. Use of the transversal filter according to one of the preceding claims as an intermediate frequency filter in consumer electronics or for precise-frequency applications

**Revendications**

1. Filtre transversal à ondes de surface

- comprenant un substrat piézoélectrique avec un convertisseur interdigital conçu comme convertisseur d'entrée (B) et avec un convertisseur interdigital conçu comme convertisseur de sortie (A),
- le convertisseur d'entrée comportant une pondération primaire pour la mise en forme de la fonction de transfert,
- l'ouverture Ap$_B$ du convertisseur d'entrée étant plus petite que l'ouverture Ap$_A$ du convertisseur de sortie,
- le convertisseur de sortie (A$_W$) comportant pour améliorer la caractéristique coupe-fréquence une pondération secondaire qui est beaucoup plus petite que la pondération primaire,
- une pondération de chevauchement étant prévue comme méthode de pondération pour la pondération primaire et pour la pondération secondaire,
- la pondération secondaire maximale dans le convertisseur de sortie (A$_W$), définie comme la différence entre la plus petite longueur de chevauchement et la plus grande longueur de chevauchement de deux doigts d'électrodes voisins de polarités différentes, vaut entre 0,5 % et 10 % de l'ouverture du convertisseur de sortie (A).

2. Filtre transversal selon la revendication 1, tel qu'au moins 95 % des pondérations de chevauchement du convertisseur de sortie (A$_W$) se trouvent en dehors de la piste, définie par l'ouverture du convertisseur d'entrée, du filtre.

**3.** Filtre transversal selon l'une des revendications 1 ou 2, tel que la longueur, mesurée dans l'axe (X) de la propagation de l'onde de surface, du convertisseur d'entrée (B) vaut au moins le triple de la longueur du convertisseur de sortie ($A_W$).

**4.** Filtre transversal selon l'une des revendications 1 à 3, tel que la pondération secondaire est optimisée pour avoir un affaiblissement maximal du filtre pour une fréquence de coupure donnée.

**5.** Utilisation du filtre transversal selon l'une des revendications précédentes comme filtre de fréquence intermédiaire dans l'électronique de divertissement ou pour des applications à fréquence exacte.

## FIG 1

$T_B2$

B

$T_B1$

W

$T_A2$

A

$T_A1$

## FIG 2

F1  F2  F3

Aw

S1

S2

FIG 3

Normalized to 0.130=-17.7 dB

EP 1 391 037 B1

measurement mean
desired behaviour

FIG 4

Normalized to
1.000=-1.929E-15dB

EP 1 391 037 B1

**EP 1 391 037 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4472653 A